# EUROPEAN PATENT SPECIFICATION

(11) **EP 3 340 752 B1**
(45) Date of publication and mention of the grant of the patent: **25.01.2023**
(21) Application number: 16206288.9
(22) Date of filing: 22.12.2016
(51) Int. Cl.: H05K 1/18, B32B 3/08, B32B 3/30, B32B 5/24, B32B 7/06, B32B 7/12, B32B 9/04, B32B 15/08, B32B 15/14, B32B 15/20, B32B 27/06, B32B 27/08, B32B 27/12, B32B 27/28, B32B 27/32, B32B 27/34, B32B 27/38, C09J 7/22, B23B 27/00, C09J 7/00, H05K 3/46

(54) **METHOD USING AN AIR PERMEABLE TEMPORARY CARRIER TAPE FOR EMBEDDING COMPONENT IN COMPONENT CARRIER**
VERFAHREN ZUR EINBETTUNG EINER KOMPONENTE IN EINEM KOMPONENTENTRÄGER MITTELS EINES LUFTDURCHLÄSSIGEN TEMPORÄREN TRÄGERBANDES
PROCÉDÉ UTILISANT UN RUBAN SUPPORT TEMPORAIRE PERMÉABLE À L'AIR PERMETTANT L'INTÉGRATION D'UN COMPOSANT DANS UN SUPPORT DE COMPOSANT

(43) Date of publication of application: 27.06.2018
(73) Proprietor: AT & S Austria Technologie & Systemtechnik Aktiengesellschaft, 8700 Leoben (AT)
(72) Inventor: Ifis, Abderrazzaq, 8700 Leoben (AT); Schrittwieser, Wolfgang, 8605 Kapfenberg (AT); Baftiri, Artan, 8700 Leoben (AT)
(74) Representative: Dilg, Haeusler, Schindelmann Patentanwaltsgesellschaft mbH

(56) References cited:
- JP-A- 2000 290 614
- JP-A- 2015 135 940
- US-A1- 2006 015 055
- US-A1- 2011 315 302
- US-A1- 2014 042 602

## Description

The invention relates to a method of manufacturing a component carrier.

In the context of growing product functionalities of component carriers equipped with one or more components and increasing miniaturization of such components as well as a rising number of components to be mounted on component carriers such as printed circuit boards, increasingly more powerful array-like components or packages having several components are being employed, which have a plurality of contacts or connections, with ever smaller spacing between these contacts.

Removal of heat generated by such components and the component carrier itself during operation becomes an increasing issue. At the same time, mounting devices shall be mechanically robust and electrically reliable so as to be operable even under harsh conditions.

It is an object of the invention to provide a manufacturing architecture for reliable component carriers.

In order to achieve the object defined above, a method of manufacturing a component carrier according to the independent claims are provided.

According to an embodiment of the invention, a method of manufacturing a component carrier is provided, wherein the method comprises adhering a tape on at least part of a main surface of a base structure having at least one accommodation through hole for accommodating a component, placing at least one component in the at least one accommodation through hole on or above the tape, at least partially filling the at least one accommodation through hole with a filler material, and removing air bubbles in the filler material through the tape.

According to this embodiment of the invention, an adhesive temporary tape with one or more airflow channels is used for embedding a component in a component carrier, in particular a printed circuit board.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "electronic component" may particularly denote any bulky rather than layer-type active (such as a semiconductor chip) or passive (for instance a copper block) component embedded within an interior of the component carrier.

In the context of the present application, the term "semifinished product" may particularly denote a physical structure which is not yet readily manufactured but requires further processing to obtain a final product which can functionally serve as stand-alone component carrier. In other words, a semifinished product may be a pre-form of a component carrier to be manufactured based on the semifinished product.

A sticky tape with one or more airflow openings is provided which is configured to be attached to a base structure during embedding of a component. Thanks to the provision of the one or more airflow openings, air bubbles and the like which may be present in adhesive material used for filling a gap between the component and the base structure/the sticky tape may escape from the arrangement via or through the airflow opening(s) of the air permeable tape. Therefore, a partially open rather than fully close temporary adhesive tape, capable of breathing during the embedding procedure, may be advantageously used for the embedding procedure so that the amount of undesired air bubbles within the accommodation through hole may be reduced. Therefore, the reproducibility and reliability (in terms of electrical, mechanical, thermal performance) of the manufactured component carrier can be significantly improved.

In the following, further exemplary embodiments of the method of manufacturing a component carrier will be explained.

In an embodiment, the base structure comprises at least one of the group consisting of a core (in particular a fully cured core, for instance an already completely cross-linked core of resin and reinforcing fibers such as FR4) and a resin structure (in particular an at least partially uncured resin structure, for example a cut-out layer of prepreg, which may comprise resin with reinforcing particles embedded therein). Alternatively, the base structure may also be a metal foil or metal layer, for instance cut-out or patterned. In the context of the present application, the term "core" may particularly denote already cured electrically insulating material providing a stable base for embedding one or more components. A core may be made of cured resin (such as epoxy resin) with fibers (such as glass fibers) embedded therein, for example FR4. In particular, such a core may be made of a thickness being higher than that of a single layer (such as a prepreg layer) as used in PCB technology. In the context of the present application, the term "fully cured" may particularly denote a material property according to which the corresponding material (such as resin) is not capable any more of being remelted to become flowable and of being subsequently re-solidified for interconnecting various elements of the manufactured component carrier. In particular, resin material of the fully cured core may be already cross-linked. Thus, the fully cured core material may be C-stage material rather than A-stage or B-stage material.

In an embodiment, the carrier foil is an air-permeable membrane. Such an air permeable membrane can provide a high mounting surface for the component and at the same time an efficient airflow capability.

In an embodiment, the at least one airflow opening comprises at least one macroscopic through-hole. By providing one or more large through holes, in particular in the same order of magnitude as the component, a highly efficient removal of gas bubbles in filler material through the membrane is possible.

In an embodiment, the at least one airflow opening comprises a pattern of through-holes (which may in particular extend in parallel through the carrier foil). Such a pattern or array may for instance be a regular pattern (for instance a matrix-like pattern of airflow openings in rows and columns) or an arbitrary pattern. The provision of multiple airflow openings in a certain pattern keeps the stability of the tape, serving as a temporary mounting base of the component, high, while simultaneously allowing for an efficient removal of air bubbles through the airflow openings.

In an embodiment, a diameter of the at least one airflow opening is at least 10 µm, in particular is in a range between 10 µm and 500 µm. This ensures an efficient gas removal from the accommodation through hole. Preferably but not necessarily, the dimension of the airflow openings may be below 25 µm , since this maintains a high stability of the tape while allowing for a sufficiently strong air communication through the thickness of the preferably bendable tape.

In an embodiment, at least one of the at least one airflow opening is located in a surface of the tape being uncovered (i.e. being not covered) with the component. By arranging at least part of the at least one airflow opening apart from the mounting surface of the component, an efficient removal of air bubbles in filler material filled into a gap between base structure and electronic component can be guaranteed.

In an embodiment, at least one of the at least one airflow opening is located in a surface of the tape being covered (after mounting) with the component. By taking this measure, an undesired accumulation of air bubbles below the component may be prevented. Such air bubbles may have the undesired effect of rendering position and orientation of the embedded electronic component undefined. Therefore, the provision of an opportunity to remove air bubbles below the lower main surface of the embedded electronic component is particularly advantageous.

In an embodiment, the semifinished product further comprises at least one component accommodated in the at least one accommodation through hole. For instance, such a component may be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite core) or may be a paramagnetic element. However, the component may also be a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the semifinished product comprises liquid adhesive as filler material filling at least part of a gap between the base structure and/or the tape on the one hand and at least one component in the at least one accommodation through hole on the other hand. Such a liquid adhesive material may be filled into the accommodation through hole before and/or after mounting the component in the accommodation through hole (the latter being only partially bridged by the for instance flexible tape).

In an embodiment, the semifinished product comprises at least one electrically insulating layer structure laminated on the base structure and at least one component in the at least one accommodation through hole, wherein part of the at least one electrically insulating layer structure serves as filler material filling at least part of a gap between the base structure and the at least one component. In the context of the present application, the term "layer structure" may particularly denote one or more full or continuous layers, one or more patterned layers, and/or a plurality of islands-type separate elements formed together within a plane. Therefore, the air bubble removing function of the tape may also be applied to an architecture in which flowable resin, liquefied by lamination, of a laminated layer structure flows into a gap between base structure and electronic component.

In an embodiment, the at least one airflow opening is formed by at least one of the group consisting of a laser treatment (in particular UV laser treatment or Excimer laser treatment), and mechanically drilling. However, other airflow opening manufacturing procedures (for instance etching) are possible as well.

In an embodiment, the at least one airflow opening is formed in the tape after adhering the tape to the base structure. Such a procedure is advantageous, since the tape may have its full support capability while mounting the component, and can be recessed selectively afterwards at one or more desired locations for permitting gas flow through the membrane.

In an alternative embodiment, the at least one airflow opening is formed in the tape before adhering the tape to the base structure. Thus, the tape may be provided with preformed airflow openings which accelerates the embedding procedure, since no formation of airflow openings is necessary during the embedding procedure.

In an embodiment, air bubbles in the filler material are removed at least partially through the tape by at least one of a vacuum treatment and an elevated temperature treatment. In particular the combination of a vacuum treatment and the formation of an elevated temperature is advantageous for triggering efficient removal of gas bubbles. By generating a negative pressure and an increased temperature in a surrounding (for instance a heated vacuum oven) of a semifinished product with base structure, tape, bubble comprising adhesive and optionally electronic component, mobility of the air bubbles may be increased and the air bubbles may be triggered to leave (in particular may be sucked out) of the adhesive, wherein the airflow opening(s) of the tape ensure(s) an efficient removal of at least part of the air bubbles out of the adhesive.

In an embodiment, the filler material is provided by inserting a liquid adhesive into a gap between the base structure and/or the tape on the one hand and at least one component in the at least one accommodation through hole on the other hand. Such a liquid adhesive may be for instance an epoxy resin adhesive.

In an embodiment, the filler material is provided by laminating a resin comprising layer structure on the base structure and the component so that resin being liquefied during lamination flows into gaps between the base structure and the component in the accommodation through-hole. Such a dielectric layer structure may for instance be a resin layer or a prepreg layer, or, more generally, an at least partially uncured dielectric layer. In the context of the present application, the term "at least partially uncured material" particularly denotes material which has the property to at least partially melt or become flowable by the application of elevated pressure and/or elevated temperature, and become fully hardened or cured (and thereby becomes solid) when releasing the applied elevated pressure and/or elevated temperature. Consequently, applying elevated pressure and/or elevated temperature may cause melting of the at least partially uncured material, followed by an irreversible hardening upon releasing the applied high pressure and/or high temperature. In particular, the "at least partially uncured material" may comprise or consist of B-stage material and/or A-stage material.

In an embodiment, the tape is removed from the base structure and the component after supplying the filler material. In other words, after curing and solidifying the filler material, the temporary tape may be removed, for instance by peeling it off. Alternatively, the tape may remain part of the final product, i.e. of the component carrier manufactured as described herein.

In an embodiment, the component carrier or the preform thereof comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier or the preform thereof is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, at least one electrically conductive layer structure of the preform comprises at least one of the group consisting of copper, aluminum, nickel, silver, gold, palladium, and tungsten. Although copper is usually preferred, other materials or coated versions thereof are possible as well, in particular coated with supra-conductive material such as graphene.

The aspects defined above and aspects of the invention are apparent from the examples of embodiment to be described hereinafter and are explained with reference to these examples of embodiment.

Figure 1 to Figure 6 illustrate different cross-sectional views of structures obtained during carrying out a method of manufacturing a component carrier according to an exemplary embodiment of the invention.

Figure 7 to Figure 19 illustrate different cross-sectional views of structures obtained during carrying out a method of manufacturing a component carrier according to another exemplary embodiment of the invention.

Figure 20 and Figure 21 illustrate different cross-sectional views of tapes carrying structures obtained during carrying out a method of manufacturing a component carrier according to yet other exemplary embodiments of the invention.

The illustrations in the drawings are schematical. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment resulting from the invention, a highly reliable embedded component package may be provided in which issues resulting from air bubbles in temporarily flowable dielectric material are prevented. Hence, an exemplary embodiment of the invention provides a bubble-poor or even bubble-free embedding process for active and passive components, sensors, interposers, or even board-in-board devices. This makes it possible to reliably avoid an undesired floating of embedded parts under a vacuum process and guarantees an accurate registration process. Furthermore, exemplary embodiments of the invention make it possible to embed components of different sizes and shapes. Moreover, it is possible to avoid resin residuals on components pads. High thermally conductive, mechanically robust and electrical reliable properties of a manufactured component carrier may be achieved. This advantageously results in a reliable behaviour of the manufactured component carrier in harsh environment, avoiding air inclusions. This drastically reduces the probability of oxidation of the component and the path for the electrochemical migration.

According to an exemplary embodiment of the invention, a design of an embedded package with very high filling degree and consequent a significantly improved reliability (in terms of thermal, chemical, mechanical and/or electrical properties) may be achieved.

In one embodiment, a corresponding manufacturing method for a component carrier comprises cavity cutting in a structured base structure, and sticky tape lamination on one side. The adhesive tape may advantageously include clearances or openings, for instance in size below 25 µm. The airflow openings or clearances can be positioned under the embedded parts, in the cavity area or both. Furthermore, it is possible to assemble the embedded parts. A resin or adhesive may be applied. Advantageously, the adhesive can have a viscosity in the range between 0,5 Pa·s to 300 Pa·s, in particular between 1 Pa·s to 150 Pa·s. Preferably, the resin should be solvent free and also have a good floating behaviour with low surface tension. According to an embodiment, a vacuum process may be applied for a certain duration depending on the base structure thickness. Preferably, the pressure can be less than 200 mbar during the vacuum treatment. It is then possible to apply a curing cycle according to the selected adhesive or resin. Subsequently, the tape may be removed. A layup and pressing process may be carried out. Furthermore, it is possible to connect the embedded part to the next layer.

In an embodiment, the included clearances in the tape allow running the vacuum process without any floating of the embedded part. Indeed, the air under the embedded part may flow through the clearance when starting the vacuum. Thus, the embedded part may get a reliable adhesion to the tape and may offer a proper registration for further processes. As a consequence of the described processing, the adhesion properties may be higher and the contacting pads may be free of plugged adhesive. Advantageously, bubbles trapped in the resin or adhesive, especially in the cavity corners, may flow through the clearance of the cavity offside of the structure. Thereby, a homogeneous thermo-mechanical behaviour may be obtained, and the delamination risk may be suppressed. Beyond this, contamination and moisture tests have proven the especially high reliability of such packages or component carriers.

Advantageously, the above mentioned selected range of the viscosity of the filler material (in particular resin or adhesive) allows a reliable bubble removal and avoids the resin or adhesive flowing through the tape. The fact that the resin (or adhesive) is solvent free avoids boiling effects caused by the vacuum process. Moreover, the described process makes it possible to embed substantially all component sizes and shapes. Packages of component carriers manufactured following the described processes show high mechanical, thermal and electrical reliability. In other words, such a manufacturing method office highly reliable embedded packages of component carriers. Moreover, a high yield can be obtained. The described manufacturing procedure is also compatible with a large choice of materials and thereby provides a board designer with a high degree of flexibility.

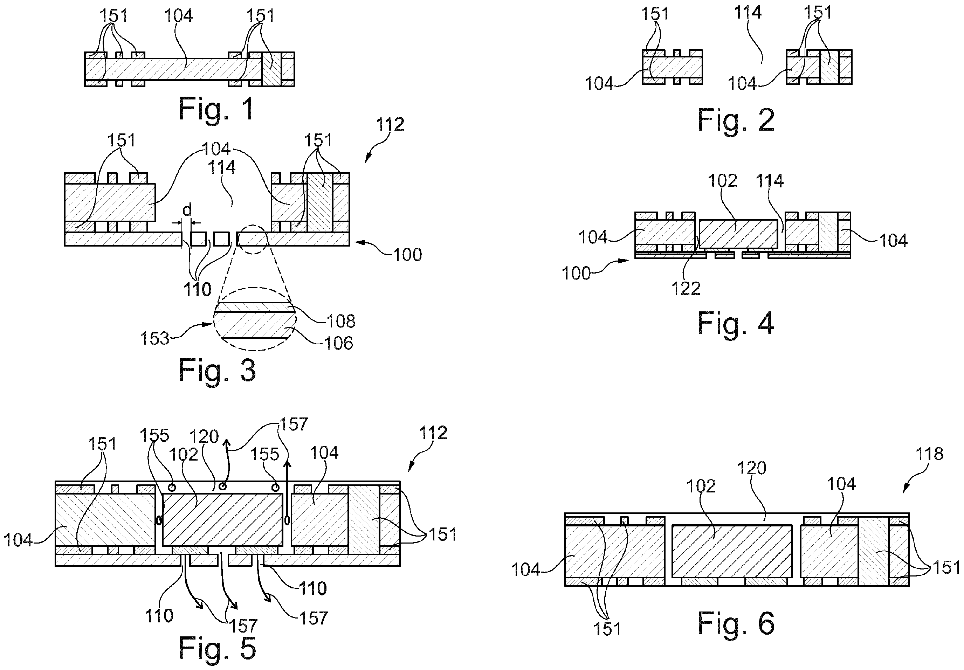

Figure 1 to Figure 6 illustrate different cross-sectional views of structures obtained during carrying out a method of manufacturing a component carrier 118 according to an exemplary embodiment of the invention.

Referring to **Figure 1****,** a base structure 104 is shown which can be a core may be made of a fully cured material such as FR4. An electrically conductive layer structure 151 is formed partially on and partially in the base structure 104 and comprises patterned electrically conductive layers (for instance copper foils) on both opposing main surfaces of the base structure 104 as well as a vertical through connection (embodied as a copper filled via). The vertical through connection may be formed by mechanically drilling and copper plating.

Referring to **Figure 2****,** a cavity cutting procedure is carried out. Consequently, an accommodation through hole 114 is formed in the base structure 104.

Referring to **Figure 3****,** a sticky tape 100 is laminated to a lower main surface of the structure shown in Figure 2. The tape 100 is configured for temporarily supporting electronic components 102 (compare Figure 4) during embedding in the base structure 104. As can be taken from a detail 153, the tape 100 comprises a carrier foil 106 (for instance made of a plastic material), an adhesive 108 (such as an epoxy resin) applied on the upper main surface of the carrier foil 106, and airflow openings 110 extending vertically through the entire tape 100 for enabling gas such as air to flow through the tape 100. The airflow openings 110 may be formed by a laser treatment (in particular UV laser treatment or Excimer laser treatment), or by mechanically drilling. In the shown embodiment, the airflow openings 110 are already readily formed in the tape 100 before adhering the tape 100 to the base structure 104. The airflow openings 110 (which may also be denoted as air channels) are arranged as a pattern of through-holes extending in parallel through the carrier foil 106 and the layer of adhesive 108. A diameter, d, of the airflow openings 110 may be for example 20 µm. This maintains tightness for a viscous liquid material (see reference numeral 120 below) but allows gas to stream or flow from the accommodation through hole 114 through the tape 100 into an environment.

By the described manufacturing procedure, semifinished product 112, as shown in Figure 3, is obtained which is composed of the base structure 104 with the accommodation through hole 114 for accommodating electronic component 102, and the tape 100 adhered to the lower main surface of the base structure 104 and only partially bridging the accommodation through hole 114 of the base structure 104. "Only partially bridging" hereby means that intentionally not the whole accommodation through hole 114 is closed by the tape 100, in contrast to this a flow of gaseous medium through the airflow openings 110 remains intentionally enabled. The airflow openings 110 are located in and extend from a surface of the tape 100 being later covered with the electronic component 102. Consequently, air bubbles in viscous medium between the electronic component 102 and the tape 100 may escape through the airflow openings 110 out of the semifinished product 112. This allows to obtain a component carrier 118 with high reliability. The shown semifinished product 112 forms a preform of such a component carrier 118 to be manufactured (compare Figure 6), here configured as a printed circuit board (PCB).

Referring to **Figure 4****,** an electronic component 102 may be assembled with the structure shown in Figure 3. More specifically, the electronic component 102 (which may for instance be a semiconductor chip, here with pads face down) may be accommodated in the accommodation through hole 114 being partially bridged by the sticky tape 100 with its airflow openings 110 being located on a mounting surface of the electronic component 102. Thus, the electronic component 102 is placed in the accommodation through hole 114 and on the tape 100 so that the airflow openings 110 are located beneath the electronic component 102.

Referring to **Figure 5****,** after the assembly described referring to Figure 4, a still unfilled portion of the accommodation through hole 114 as well as a volume above the electronic component 102 and the base structure 104 is filled with a viscous liquid filler material 120. This filler material 120 may be a liquid adhesive 108 (for instance an epoxy resin) and may in particular fill a gap 122 between the base structure 104 and the tape 104 on the one hand and the electronic component 102 in the accommodation through hole 114 on the other hand. In other words, the structure shown in Figure 4 may be provided with a resin plug.

As can be taken from Figure 5, air bubbles 155 may be present in the filler material 120. Such air bubbles 155 are highly disturbing since they may negatively influence the reliability of the manufactured component carrier 118. In order to remove at least part of the air bubbles 155 in the filler material 120, the structure shown in Figure 5 is made subject to a vacuum treatment at elevated temperature. As a result of this treatment, at least part of the air bubbles 155 leaves the filler material 120, as indicated by reference numeral 157. Highly advantageously, part of the air bubbles 157 may also escape the airflow openings 110. Thus, exemplary embodiments of the invention may render it impossible that a large amount of air bubbles 155 accumulate close to the sticky tape 100. Thereby, it becomes possible to remove air bubbles 155 in the filler material 120 through the tape 100. This improves electric reliability, thermal performance and mechanical robustness of the component carrier 118 shown in Figure 6.

Referring to **Figure 6****,** the temporary tape 100 can be removed from the base structure 104 and the electronic component 102 after supplying and curing the filler material 120 and after having removed at least part of the air bubbles 155 at least partially through the airflow openings 110.

The structure shown in Figure 6 can be already used as component carrier 118. Alternatively, it is possible to laminate at least one electrically conductive layer structure (for instance of copper, or alternatively of aluminium or nickel) and/or at least one electrically insulating layer structure (in particular one or more prepreg layers, which may comprise resin such as epoxy resin and reinforcing fibers such as glass fibers) on either of the two opposing main surfaces of the component carrier 118 (not shown). Thereby, also a multilayer component carrier 118 may be manufactured.

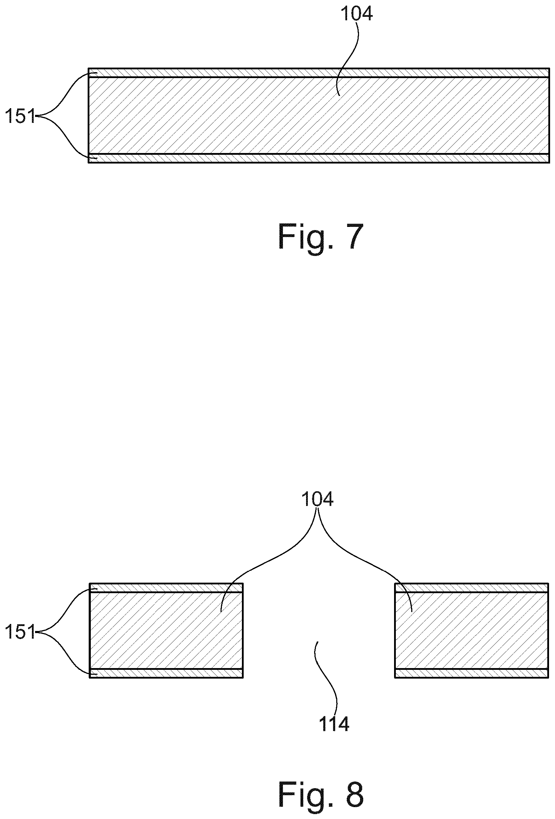

Figure 7 to Figure 19 illustrate different cross-sectional views of structures obtained during carrying out a method of manufacturing a component carrier 118 according to another exemplary embodiment of the invention.

Referring to **Figure 7****,** a fully cured base structure 104 (for instance made of FR4, i.e. composed of cured resin and glass fibers) is provided which comprises a copper foil as electrically conductive layer structure 151 on both opposing main surfaces thereof.

Referring to **Figure 8****,** an accommodation hole 114 is formed in the base structure 104.

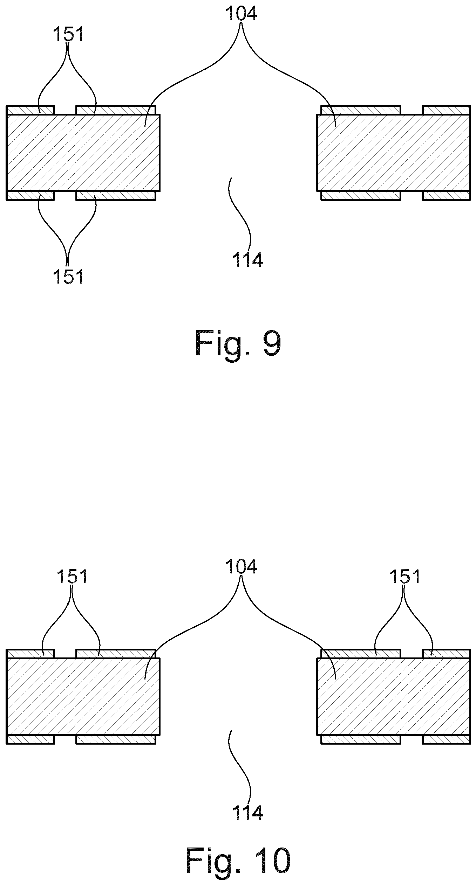

Referring to **Figure 9****,** the full copper layers of the electrically conductive layer structure 151 on both of opposing main surfaces of the recessed base structure 104 are structured or patterned to thereby obtain a predefined wiring structure.

Referring to **Figure 10****,** the exposed surface of the structure shown in Figure 9 may be made subject of a surface treatment (for instance roughening) for improving adhesion of additional material, which is connected in accordance with the following illustrations.

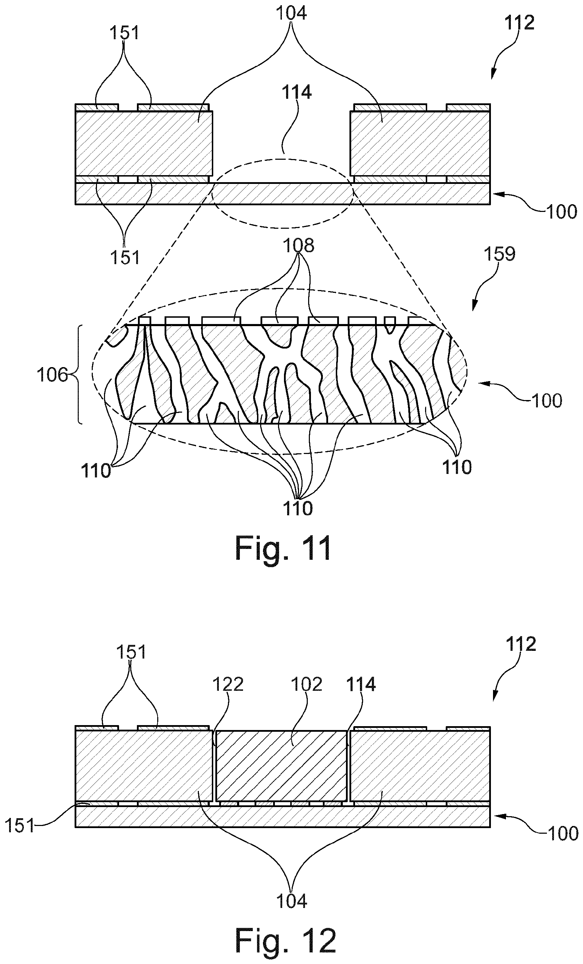

Referring to **Figure 11****,** bendable sticky tape 100 is laminated, as temporary carrier, onto the base structure 104 with the patterned electrically conductive layer structure 151 provided thereon. In the described embodiment, the tape 100 is configured as an air-permeable membrane. In other words, the airflow openings 110 of the air permeable tape 100 according to Figure 11 are formed as pores of the porous air permeable membrane (compare detail 159). The dimension of the pores can be adjusted so that airflow is enabled through the pores. For example, an average diameter of the pores may be 10 µm.

Referring to **Figure 12****,** electronic component 102 is inserted into the accommodation through hole 104 and is adhered on the adhesive 108 on the porous carrier 104.

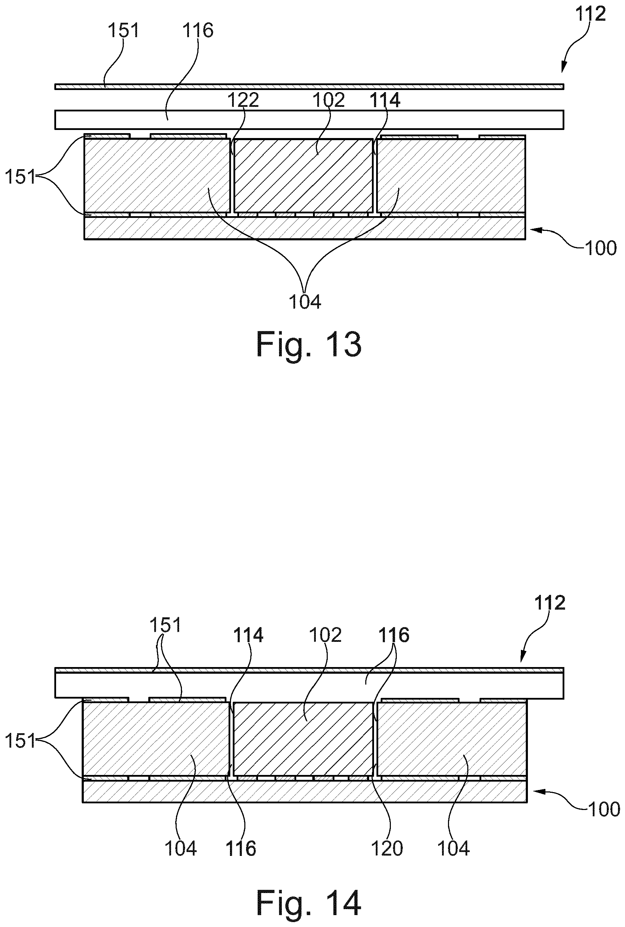

Referring to **Figure 13****,** an electrically insulating layer structure 116 (for instance made of an at least partially uncured material such as resin or pre-prepreg) as well as a further electrically conductive layer structure 151 (for example a further copper foil) can be laminated on the base structure 104 and the electronic component 102 in the accommodation through hole 114. Lamination may be accomplished by applying mechanical pressure, if desired supported by heat.

Referring to **Figure 14****,** the result of the above described lamination procedure is shown. During the lamination, the at least partially uncured material of the electrically insulating layer structure 116 becomes temporarily flowable, and hence flows also in a previously unfilled gap 122 delimited between base structure 104, tape 100 and electronic component 102. Thereby, part of the electrically insulating layer structure 116 serves as filler material 120 filling the gap 122 between the base structure 104 and the electronic component 102. Another portion of the dielectric material of the electrically insulating layer structure 116 covers the base structure 104 with the electrically conductive layer structure 151 thereon. Hence, the filler material 120 is provided by laminating resin comprising electrically insulating layer structure 116 on the base structure 104 and the electronic component 102 so that resin being liquefied or becoming flowable during lamination flows into the gaps 122. Thereafter, the resin material cures and is finally re-solidified. However, during the lamination procedure, the flowable resin material may also have one or more air bubbles 155 in its interior (not shown). Thanks to the provision of the permeable tape 104 with its airflow openings 110 (compare Figure 11), at least part of the air bubbles 155 may escape through the tape 100 towards an environment. This improves the electrical, mechanical and thermal performance of the manufactured component carrier 118.

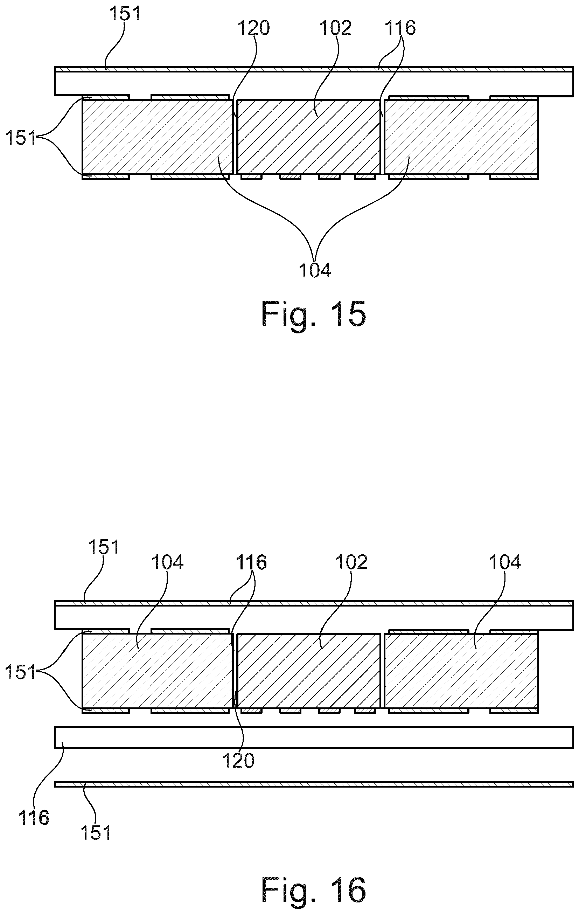

Referring to **Figure 15****,** the temporary carrier or tape 100 is removed. For instance, the tape 100 may be peeled off from the rest of the structure shown in Figure 14.

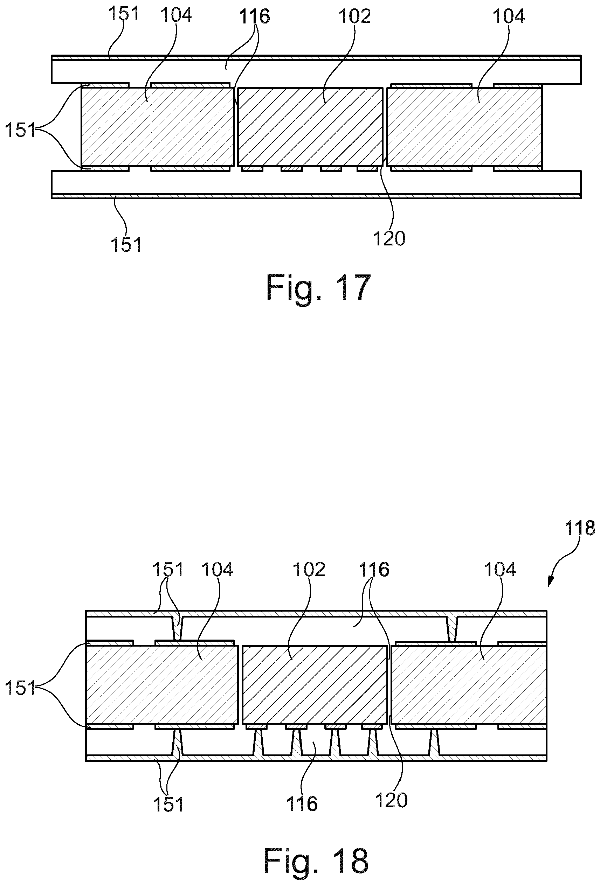

Referring to **Figure 16****,** on the backside of the structure (or the lower main surface according to Figure 16), a further electrically insulating layer structure 116 (for instance a further prepreg layer) as well as a further electrically conductive layer structure 151 (for instance a further copper foil) may be attached, and connected by lamination, compare **Figure 17****.**

Referring to **Figure 18****,** laser vias may be etched and may be filled with electrically conductive material (for instance by plating, in particular copper plating) so that electrically conductive contacts are formed for contacting the electronic component 102 as well as the wiring structure on the base structure 104.

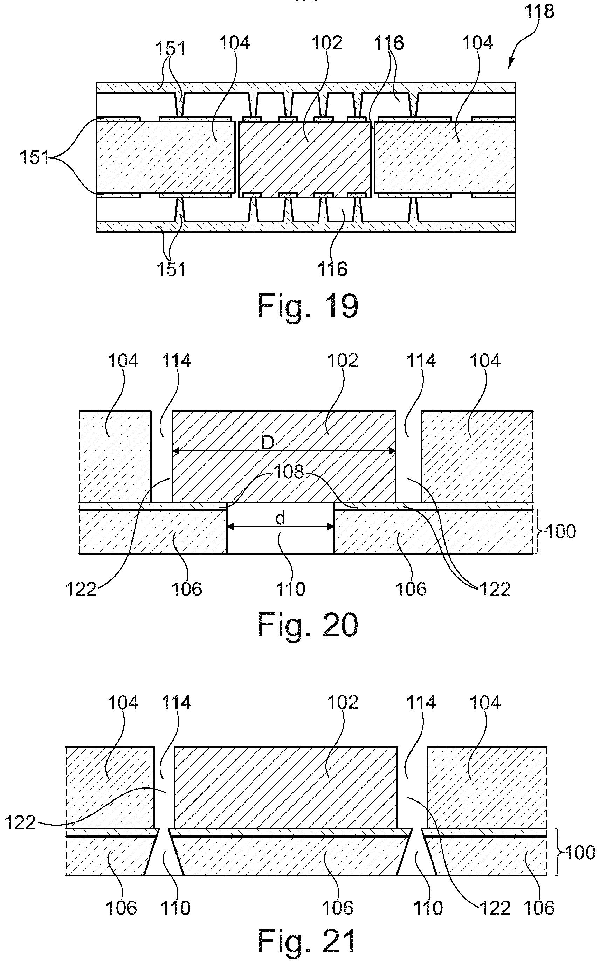

**Figure 19** illustrates that, as an alternative to the contacting of the electronic component 102 only on one main surface thereof, it is alternatively also possible to contact both opposing main surfaces of the electronic component 102 (in case that pads are formed on both opposing main surfaces of the electronic component 102).

Figure 20 and Figure 21 illustrate different cross-sectional views of tapes 100 on structures obtained during carrying out a method of manufacturing a component carrier 118 according to yet other exemplary embodiments of the invention.

Referring to **Figure 20****,** an embodiment is shown in which the airflow opening 110 is configured as macroscopic through-hole. The term "macroscopic through-hole" may denote that a size, d, of the airflow opening 100 has the same order of magnitude as the electronic component 102. For instance, the size, d, of the macroscopic through hole according to Figure 20 may be in a range between 10% and 90% of the size, D, of the electronic component 102.

Referring to **Figure 21****,** the airflow openings 110 are formed in the tape 100 only after adhering the tape 100 to the base structure 104, for instance by laser drilling from a bottom side according to Figure 21. Spatial accuracy of the formation of the airflow openings 110 may be very high with this procedure.

Furthermore, the airflow openings 110 are located, according to Figure 21, in a surface of the tape 100 being uncovered with the electronic component 102. This allows to efficiently remove air bubbles 155 of adhesive filler material 120 in a lateral gap 122 between base structure 104 and electronic component 102.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention defined by the claims even in the case of fundamentally different embodiments.

## Claims

1. A method of manufacturing a component carrier (118), wherein the method comprises:
adhering by lamination a tape (100) on at least part of a main surface of a base structure (104) having at least one accommodation through hole (114) for accommodating a component (102);
placing at least one component (102) in the at least one accommodation through hole (114) on or above the tape (100);
at least partially filling the at least one accommodation through hole (114) with a filler material (120) by pressurized lamination;
**characterised by** the tape (100) comprising at least one airflow opening (110) extending through the tape (100) for enabling air to flow through the tape (100); and
removing air bubbles (155) in the filler material (120) through the tape (100).

2. The method according to claim 1, wherein the tape (100) is a tape (100) configured to be laminatable onto the base structure (104) and wherein the tape (100) comprises a carrier foil (106) and an adhesive (108) applied on at least a part of at least one main surface of the carrier foil (106).

3. The method according to claim 1, wherein the at least one airflow opening (110) is formed by at least one of the group consisting of a laser treatment, in particular UV laser treatment or Excimer laser treatment, and mechanically drilling.

4. The method according to claim 2 or 3, comprising one of the following features:
wherein the at least one airflow opening (110) is formed in the tape (100) after adhering the tape (100) to the base structure (104);
wherein the at least one airflow opening (110) is formed in the tape (100) before adhering the tape (100) to the base structure (104).

5. The method according to any of claims 1 to 4, wherein air bubbles (155) in the filler material (120) are removed at least partially through the tape (100) by at least one of a vacuum treatment and an elevated temperature treatment, in particular by a vacuum treatment at elevated temperature.

6. The method according to any of claims 1 to 5, comprising one of the following features:
wherein the filler material (120) is provided by inserting a liquid adhesive material into a gap (122) between the base structure (104) and/or the tape (104) on the one hand and at least one component (102) in the at least one accommodation through hole (114) on the other hand;
wherein the filler material (120) is provided by laminating a resin comprising layer structure (116) on the base structure (104) and the component (102) so that resin becoming flowable during lamination flows into a gap (122) between the base structure (104) and the component (102) in the accommodation through hole (114).

7. The method according to any of claims 1 to 6, wherein the tape (100) is removed from the base structure (104) and the component (102) after supplying the filler material (120).

## Patentansprüche

1. Ein Verfahren zum Herstellen eines Komponententrägers (118), wobei das Verfahren aufweist:
Kleben mittels Lamination eines Tapes (100) auf zumindest einen Teil einer Hauptoberfläche einer Basisstruktur (104), welche mindestens eine Aufnahmedurchgangsöffnung (114) zum Aufnehmen einer Komponente (102) hat;
Platzieren mindestens einer Komponente (102) in der mindestens einen Aufnahmedurchgangsöffnung (114) auf oder über dem Tape (100);
zumindest teilweises Füllen der mindestens einen Aufnahmedurchgangsöffnung (114) mit einem Füllmaterial (120) mittels druckbeaufschlagter Lamination;
**dadurch gekennzeichnet, dass**
das Tape (100) mindestens eine Luftstromöffnung (110) aufweist, welche sich durch das Tape (100) erstreckt, um Luft zu ermöglichen, durch das Tape (100) zu strömen; und
Entfernen von Luftblasen (155) in dem Füllmaterial (120) durch das Tape (100).

2. Das Verfahren gemäß Anspruch 1, wobei das Tape (100) ein Tape (100) ist, welches konfiguriert ist, auf die Basisstruktur (104) laminierbar zu sein, und wobei das Tape (100) eine Trägerfolie (106) und einen Kleber (108) aufweist, welcher auf zumindest einem Teil von mindestens einer Hauptoberfläche der Trägerfolie (106) aufgebracht ist.

3. Das Verfahren gemäß Anspruch 1, wobei die mindestens eine Luftstromöffnung (110) mittels mindestens einem aus der Gruppe gebildet ist, bestehend aus einer Laserbehandlung, insbesondere einer UV Laserbehandlung oder einer Excimer Laserbehandlung, und mechanischem Bohren.

4. Das Verfahren gemäß Anspruch 2 oder 3, aufweisend eines der folgenden Merkmale:
wobei die mindestens eine Luftstromöffnung (110) in dem Tape (100) gebildet wird, nachdem das Tape (100) an die Basisstruktur (104) geklebt wird;
wobei die mindestens eine Luftstromöffnung (110) in dem Tape (100) gebildet wird, bevor das Tape (100) an die Basisstruktur (104) geklebt wird.

5. Das Verfahren gemäß einem beliebigen der Ansprüche 1 bis 4, wobei die Luftblasen (155) in dem Füllmaterial (120) zumindest teilweise durch das Tape (100) entfernt werden, mittels mindestens einem von einer Vakuumbehandlung und einer Behandlung bei erhöhter Temperatur, insbesondere mittels einer Vakuumbehandlung bei einer erhöhten Temperatur.

6. Das Verfahren gemäß einem beliebigen der Ansprüche 1 bis 5, aufweisend eines der folgenden Merkmale:
wobei das Füllmaterial (120) mittels Einsetzens eines flüssigen Klebstoffmaterials in eine Lücke (122) zwischen der Basisstruktur (104) und/oder dem Tape (104) einerseits und mindestens einer Komponente (102) in der mindestens einen Aufnahmedurchgangsöffnung (114) andererseits bereitgestellt wird;
wobei das Füllmaterial (120) mittels Laminierens einer Harz aufweisenden Schichtstruktur (116) auf die Basisstruktur (104) und die Komponente (102) bereitgestellt wird, so dass das Harz, welches während der Lamination fließfähig wird, in eine Lücke (122) zwischen der Basisstruktur (104) und der Komponente (102) in der Aufnahmedurchgangsöffnung (114) fließt.

7. Das Verfahren gemäß einem beliebigen der Ansprüche 1 bis 6, wobei das Tape (100) von der Basisstruktur (104) und der Komponente (102) nach dem Zuführen des Füllmaterials (120) entfernt wird.

## Revendications

1. Un procédé de fabrication d'un support de composants (118), le procédé comprenant :
le fait de faire adhérer par stratifiant une bande (100) sur au moins une partie d'une surface principale d'une structure de base (104) comportant au moins un trou traversant de logement (114) pour loger un composant (102) ;
le fait de placer au moins un composant (102) dans ledit au moins un trou traversant de logement (114) sur ou au-dessus de la bande (100) ;
le fait de remplir au moins partiellement ledit au moins un trou traversant de logement (114) avec un matériau de remplissage (120) par stratification sous pression ;
**caractérisé par le fait que** la bande (100) comprend au moins une ouverture (110) d'écoulement d'air s'étendant à travers la bande (100) pour permettre à de l'air de s'écouler à travers la bande (100) ; et
le fait d'éliminer des bulles d'air (155) dans le matériau de remplissage (120) à travers la bande (100).

2. Le procédé selon la revendication 1, dans lequel la bande (100) est une bande (100) configuré pour être apte à être stratifié sur la structure de base (104) et dans lequel la bande (100) comprend une feuille de support (106) et un adhésif (108) appliqué sur au moins une partie d'au moins une surface principale de la feuille de support (106).

3. Le procédé selon la revendication 1, dans lequel ladite au moins une ouverture (110) d'écoulement d'air est formée par au moins un membre du groupe constitué par un traitement laser, notamment un traitement par laser UV ou un traitement par laser Excimer, et un perçage mécanique.

4. Le procédé selon la revendication 2 ou la revendication 3, comprenant l'une des caractéristiques suivantes :
ladite au moins une ouverture (110) d'écoulement d'air est formée dans la bande (100) après avoir fait adhérer la bande (100) à la structure de base (104) ;
ladite au moins une ouverture (110) d'écoulement d'air est formée dans la bande (100) avant de faire adhérer la bande (100) à la structure de base (104).

5. Le procédé selon l'une quelconque des revendications 1 à 4, dans lequel des bulles d'air (155) dans le matériau de remplissage (120) sont éliminées au moins partiellement à travers la bande (100) par au moins un parmi un traitement sous vide et un traitement à une température élevée, notamment par un traitement sous vide à une température élevée.

6. Le procédé selon l'une quelconque des revendications 1 à 5, comprenant l'une des caractéristiques suivantes :
le matériau de remplissage (120) est fourni en insérant un matériau adhésif liquide dans un espace (122) entre la structure de base (104) et/ou la bande (104) d'une part et au moins un composant (102) dans ledit au moins un trou traversant de logement (114) d'autre part ;
le matériau de remplissage (120) est fourni en stratifiant une résine comprenant une structure en couches (116) sur la structure de base (104) et le composant (102) de sorte que la résine, devenant fluide pendant la stratification, s'écoule dans un espace (122) entre la structure de base (104) et le composant (102) dans le trou traversant de logement (114).

7. Le procédé selon l'une quelconque des revendications 1 à 6, dans lequel la bande (100) est retirée de la structure de base (104) et du composant (102) après l'alimentation en matériau de remplissage (120).
